# EUROPÄISCHE PATENTSCHRIFT

(11) **EP 0 514 620 B1**
(45) Veröffentlichungstag und Bekanntmachung des Hinweises auf die Patenterteilung: **19.04.1995**
(21) Anmeldenummer: 92101169.8
(22) Anmeldetag: 24.01.1992
(51) Int. Cl.: H05K 9/00

(54) **Bauteil im wesentlichen aus Kunststoff mit einer elektromagnetischen Abschirmung**
Component part essentially of plastics with electromagnetic shielding
Partie constituée essentiellement de matière synthétique ayant du blindage électromagnétique

(30) Priorität: 18.05.1991 DE 4116449
(43) Veröffentlichungstag der Anmeldung: 25.11.1992
(73) Patentinhaber: Eurocopter Deutschland Gesellschaft mit beschränkter Haftung, D-81611 München (DE)
(72) Erfinder: von Panajott, Andreas, W-8202 Bad Aibling (DE)
(74) Vertreter: Frick, Gerhard, Dipl.-Ing.

(56) Entgegenhaltungen:
- EP-A- 0 048 488
- DE-B- 2 221 786
- IBM TECHNICAL DISCLOSURE BULLETIN, Band 27, Nr. 3, August 1984, Seite 1730, New York, US; O.V. BERRY: "Metallic filled structural foam machine cabinets"

## Beschreibung

Die EP-A- 0 486 886 mit Priorität vom 22.11.90 (Art. 54 (3,4)) betrifft eine Anordnung zum Abdichten einer Trenn- oder Verbindungsfuge zwischen zwei Bauteilen gemäß dem Oberbegriff des Patentanspruches 1, wobei die Metallfolie an ihrer Kontaktfläche durch eine fluiddichte, flexible, elektrisch leitende Berührungsdichtung in der Fuge abgedeckt ist. An solchen Bauteilen sind in aller Regel auch Gegenstände zu befestigen, welche an die elektromagnetische Abschirmung in der Bauteiloberfläche beispielsweise mittels Massebolzen anzuschließen sind.

Der Erfindung liegt die Aufgabe zugrunde, auch für solche Anschlüsse Beschädigungen der Abschirmung im Bauteil infolge des erforderlichen Abtrages von Oberflächenkunststoff ohne Minderung des elektrischen Kontaktes zwischen den betreffenden Gegenständen bzw. deren Anschlußmitteln und der Abschirmung auszuschließen.

Diese Aufgabe ist mit dem kennzeichnenden Merkmal des Patentanspruchs gelöst. Hiernach ist die Metallfolie zur Abdeckung der Abschirmung nicht auf die in der vorgenannten EP-Patentanmeldung beanspruchte Dichtungsanordnung beschränkt.

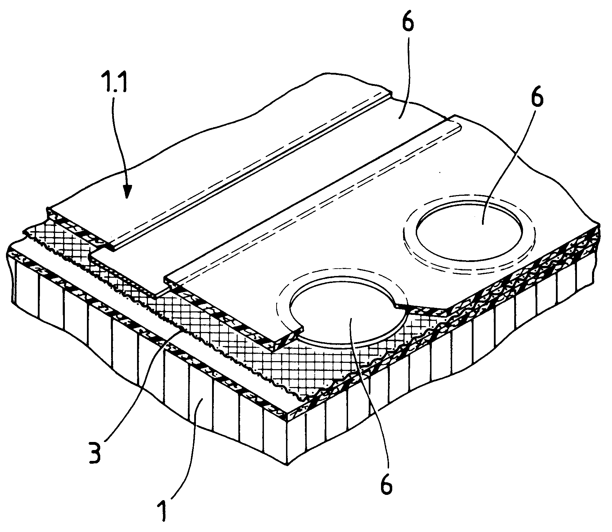

Nachfolgend wird die Erfindung anhand eines Ausführungsbeispiels weiter erläutert. Dabei zeigt die Zeichnung in einer Perspektive einen Ausschnitt aus einem Kunststoffbauteil 1, z.B. einer Behälterwandung mit Sandwichstruktur, woran nicht dargestellte Geräte befestigt werden sollen. Das Kunststoffbauteil 1 hat in der Kunststoffoberfläche 1.1 eine elektromagnetische Abschirmung 3 in Form eines Metalldrahtgeflechtes für einen elektrischen Flächenkontakt mit nicht dargestellten metallischen Massebolzen o. dgl. elektrisch leitenden Verbindungsmitteln der vorgenannten Geräte oder sonstiger Gegenstände (z.B. Antennen). Dazu ist die Abschirmung 3 in den betreffenden Bereichen jeweils frei von Oberflächenkunststoff und mit einer Metallfolie 6 vorzugsweise aus demselben Werkstoff, z.B. Kupfer, bedeckt, welche nach Maßgabe der erforderlichen Kontaktfläche von der abdeckenden Kunststoffoberfläche 1.1 befreit ist: diese sichert im übrigen den Verbund der Metallfolie 6 mit der Abschirmung 3. Die Metallfolie 6 wird bereits bei der Fertigung des Kunststoffbauteils 1 zusammen mit der Abschirmung 3 in der Bauteil- bzw. Kunststoffoberfläche 1.1 an sämtlichen Fügestellen der Bauteiloberfläche mit an die Abschirmung 3 anzuschließenden Gegenständen eingebettet, um dann eine verschleißsichere Abdeckung der Abschirmung 3 zu gewährleisten. Die jeweils erforderliche Kontaktfläche kann infolgedessen einfach durch einen Abtrag der Kunststoffoberfläche 1.1 an den betreffenden Stellen mittels Sandstrahlen geschaffen werden ohne die Gefahr einer Beschädigung der Abschirmung 3.

## Patentansprüche

1. Bauteil aus Kunststoff mit einer in der Oberfläche eingebetteten mittels einem Metalldraht hergestellten elektromagnetischen Abschirmung (3), wobei das Bauteil an sämtlichen Fügestellen der Bauteiloberfläche zum Anschließen von Geräten an die Abschirmung (3) mittels elektrisch leitender Verbindungsmittel in einem bestimmten Bereich frei von Oberflächenkunststoff ist und wobei in diesem Bereich die Abschirmung (3) mit einer Metallfolie (6) bedeckt ist, die nach Maßgabe der erforderlichen Kontaktfläche von einer den Metallfolienverbund mit der Abschirmung (3) sichernden Kunststoffdecklage (1.1) befreit ist.

## Claims

1. A plastic component with an electromagnetic screen (3), which is embedded in the surface and made of metal wire, in which respect the component is on all joints of the component surface in a specified area free of surface plastic so as to facilitate the connection of equipment to the screen (3) by means of electrically conductive connectors, and that the screen (3) in this area is covered with a metal foil (6) which is, according to a required contact surface, freed from a plastic layer (1.1) which secures the metal-foil composition with the screen (3).

## Revendications

1. Elément de construction en matériau synthétique comportant un blindage (3) électromagnétique noyé dans la surface et fabriqué à partir de fil métallique, l'élément de construction ne comportant pas decouche superficielle de matériau synthétique à l'intérieur d'une zone prédéterminée, au niveau de tous les points d'assemblage de la surface de l'élément prévus aux fins de connecter des appareils au blindage (3) par des moyens de liaison électro-conducteurs et le blindage (3), dans cette région, étant recouvert d'une feuille métallique (6) qui, en fonction de la surface de contact nécessaire, est débarrassée d'une couche de revêtement en matière plastique (1.1) qui protège l'assemblage feuille métallique blindage (3).
